Europäisches Patentamt

European Patent Office

Office européen des brevets

(11) Publication number: **0 142 258**
**B1**

(12) **EUROPEAN PATENT SPECIFICATION**

(45) Date of publication of patent specification: **01.02.89**

(21) Application number: **84306846.1**

(22) Date of filing: **08.10.84**

(51) Int. Cl.⁴: **H 01 L 27/08,** G 05 F 3/20

(54) **Method and apparatus for controlling latch-up in CMOS circuits.**

(30) Priority: **16.11.83 US 552249**

(43) Date of publication of application:
**22.05.85 Bulletin 85/21**

(45) Publication of the grant of the patent:
**01.02.89 Bulletin 89/05**

(84) Designated Contracting States:
**DE FR GB NL**

(56) References cited:
**US-A-4 039 869**
**US-A-4 353·105**

**PATENTS ABSTRACTS OF JAPAN, vol. 7, no.
140 (E-182) (1285), June 18, 1983 & JP-A-58 52
869**

**PATENTS ABSTRACTS OF JAPAN, vol. 7, no.
72 (E-166)(1217), March 25, 1983 & JP-A-58
2061**

**PATENTS ABSTRACTS OF JAPAN, vol. 7, no.
178 (E-191)(1323), August 6, 1983 & JP-A-58 82
560**

(73) Proprietor: **INMOS CORPORATION
P.O. Box 16000
Colorado Springs Colorado 80935 (US)**

(72) Inventor: **Eaton, Sargent Sheffield, Jr.
3361 Springridge Circle
Colorado Springs CO 80906 (US)**

(74) Representative: **Needle, Jacqueline et al
PAGE, WHITE & FARRER 5 Plough Place New
Fetter Lane
London EC4A 1HY (GB)**

Courier Press, Leamington Spa, England.

**Description**

The present invention relates to overcoming the problem of latch-up in CMOS circuitry.

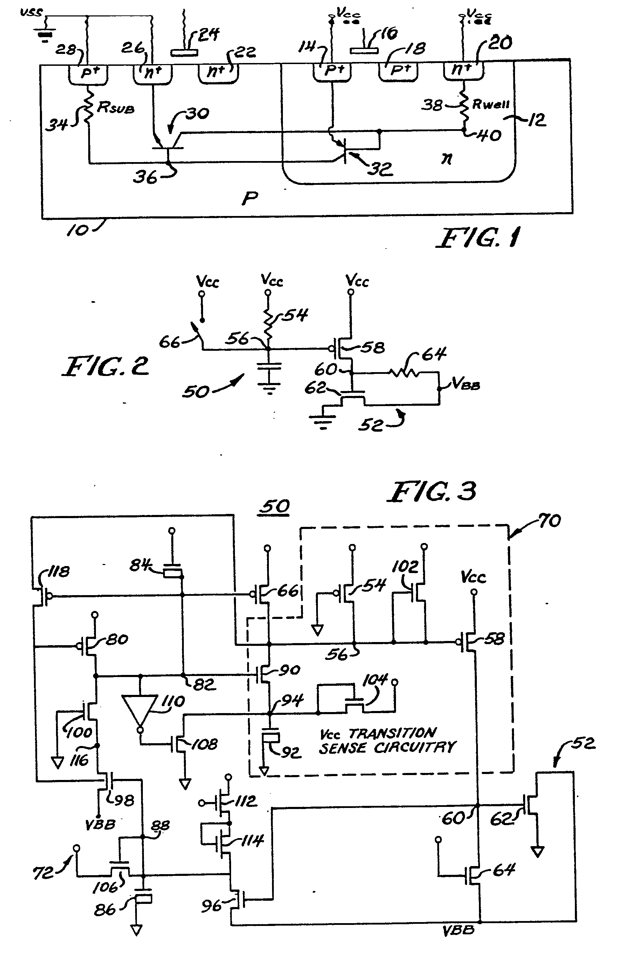

Figure 1 shows a representative cross-sectional view of a portion of a standard N well CMOS transistor arrangement. As illustrated, Figure 1 includes a P-type substrate 10 having an N-type well 12. Within the N well 12 are a P+ moat 14 and another P+ moat 18 which together with a gate 16 form an MOS device. Moat 14 is connected to a voltage source Vcc. Also within well 12 is an N+ moat 20 also connected to Vcc.

Out side of the well 12, there is an N+ region 22, and another N+ region 26 which together with a gate 26 form another MOS transistor. A P+ moat 28 is also included, and moats 26 and 28 are grounded by connection to Vss.

Certain parasitic structures are illustrated in Figure 1. An NPN transistor 30 is shown at the left side in the P substrate, and a PNP transistor 32 is shown at the right in the N well. The collector of the transistor 30 is the N well 12, its base is the P substrate and its emitter is N+ moat 26. With regard to the transistor 32, its collector is the P type substrate 10, its base is the N well 12, and its emitter is the P+-type moat 14.

There are resistances between the bases of the transistors 30 and 32 and the substrate or well contacts. With respect to the transistor 30, a substrate resistance 34 exists between the base of the transistor 30 and the moat 28. A node 36 is schematically located at the base of the transistor 30. With respect to the transistor 32, a resistance 38 exists between its base and the N+ moat 20. A node 40 is schematically located between the resistance 38 and the base of the transistor 32. It will be seen that node 36 is electrically connected to the base of the transistor 30 and to the collector of the transistor 32. Similarly, the node 40 is electrically connected to the base of the transistor 32 and to the collector of the transistor 30.

The problem of latch-up can now be illustrated. If, in the arrangement of Figure 1, the transistor 32 is turned ON, current passes through the node 36, causing the voltage at node 36 to rise. This turns ON the transistor 30. This in turn causes a current at node 40, which pulls down the voltage at node 40. This turns ON transistor 32 even harder. This causes the current to increase, causing the voltage at node 36 to rise even more. This in turn causes the transistor 30 to turn ON even harder, which has the effect of increasing the current through node 40. It will be seen that this is an ever increasing routine. This circumstance can be triggered by a base current in either the transistor 30 or the transistor 32. It can be induced by a wide variety of things, including rapid changes in a power supply voltage, light, radiation, input and output over voltage, and on-chip capacitive disturbances. When this occurs, it is referred to by the art as "latch-up".

It is an object of the present invention to devise a method and apparatus which overcomes the problem of latch-up in CMOS circuits.

According to a first aspect of the present invention there is provided a method for controlling latch-up in a CMOS circuit on a substrate comprising operating the CMOS circuit, biasing the substrate during normal circuit operation with a charge pump on the substrate to a voltage to prevent latch up, sensing a power supply transition, clamping the substrate to a known potential in response to sensing said power supply transition, and releasing said clamping after said power supply transition.

The present invention also extends to apparatus for controlling latch-up in a CMOS circuit on a substrate comprising a bias circuit coupled to the substrate, for controlling the potential of the substrate on which the CMOS circuit is located, means for selectively engaging said bias circuit, a sensing circuit for sensing a power supply transition, said bias circuit being responsive to said sensing circuit, and a clamping circuit for clamping the substrate to a known potential in response to a power supply transition sensed by said sensing circuit, said clamping circuit being arranged to release said clamp after said power supply transition.

With a combination of a substrate clamp and a substrate bias circuit in the form of a charge pump, the substrate clamp can be arranged to hold the substrate to ground on power-up and thus to prevent latch-up by holding the NPN transistor, for example, OFF. After power-up, the on-chip substrate bias circuit creates a negative voltage sufficient to prevent latch-up during normal operation of the circuits on the substrate.

In an embodiment, the substrate capacitance to ground is arranged to be high compared to any capacitance coupling to the substrate from other sources.

In a preferred embodiment, the substrate clamp operates by sensing a power supply transition and a large transistor is used to hold the substrate to ground while Vcc is changing.

To distinguish between a power-up condition and normal Vcc disturbances after power-up, circuitry is preferably included to turn off the transition sense circuitry once VBB has pumped down to an acceptably low level.

It has been found that with the invention, a CMOS circuit can be made latch-up free during initial power up as well as during normal operation.

In one embodiment of apparatus of the invention said clamping circuit includes a clamping transistor having its source-drain path coupling the substrate to ground, and wherein a control transistor has its source-drain path coupled to connect a power supply voltage to the gate of said clamping transistor, and wherein means are coupled to the gate of said control transistor for turning on said control transistor in response to a power supply transition.

The present invention does not allow both parasitic transistors on the substrate to turn ON at the same time. Furthermore, one of the nodes is biased with a negative potential, thereby preventing the transistor whose base is connected to the node from turning ON.

Embodiments of the present invention will hereinafter be described, by way of example, with reference to the accompanying drawings, in which:

Figure 1 shows a representative cross-sectional view of part of a CMOS circuit arrangement in which inherent parasitic devices are represented,

Figure 2 shows schematically a simplified circuit for use in the present invention,

Figure 3 is a schematic diagram of a further embodiment of a circuit of the present invention,

Figure 4 shows schematically the physical relationship of the substrate of a substrate clamp, other on-chip circuits, and a charge pump,

Figure 5 illustrates the addition of capacitance to the substrate, and

Figure 6 shows schematically a circuit arrangement similar to that of Figure 1 but modified to have high substrate capacitance.

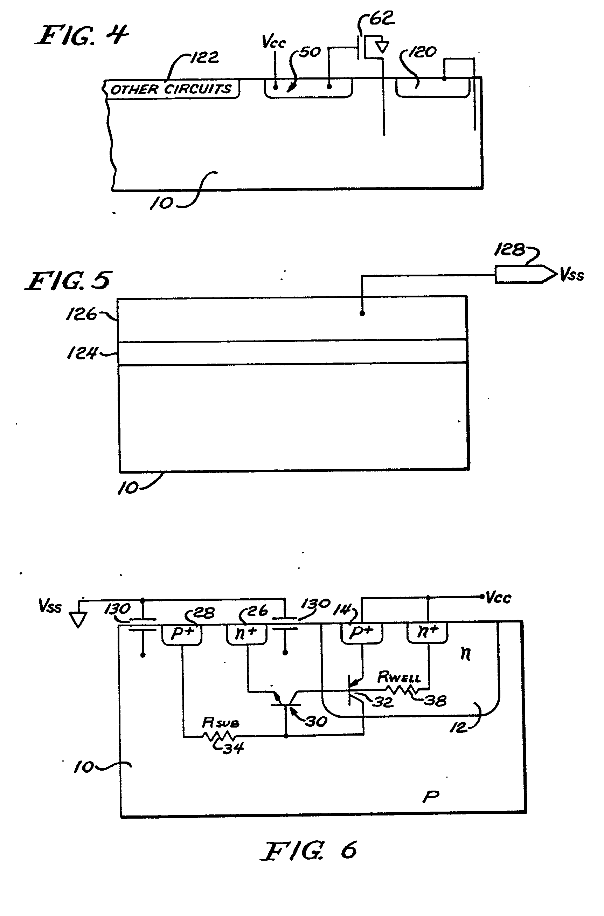

Figure 2 shows schematically a simplified version of a circuit 50 of the present invention for controlling latch-up in a CMOS circuit during initial power up of the CMOS circuit, which circuit 50 includes a clamp portion 52. The CMOS circuit will include substrate biasing means to prevent latch up during normal operation. In Figure 2, according to a convention which is also used in Figures 1 and 3, each unconnected small circle in the circuit diagrams represents a connection to the voltage source Vcc. Circuit 50 is formed on the substrate 10 of Figure 1, and has the physical and spatial relationship to other circuits on the substrate illustrated in Figure 4. During a power-up condition, due to a resistance 54, a node 56 lags behind Vcc. In the preferred embodiment, as will be seen in Figure 3, the resistance 54 is a high impedance transistor. Because of this lag, a transistor 58, which is a P channel device, is turned ON. As a result, the transistor 58 couples Vcc to a node 60 which is coupled electrically to the gate of a transistor 62 and turns the transistor 62 ON. The source-drain path of the transistor 62 couples the substrate VBB to ground. Thus, during power-up conditions, the substrate 10 (Figure 1) is clamped to ground and therefore latch-up does not occur.

After Vcc becomes stable, node 56 catches up to Vcc; this turns the transistor 58 OFF. A resistance 64 (which is in the preferred embodiment a high impedance N channel FET) is connected between the substrate VBB and the node 60. Consequently, the voltage at node 60 will eventually reach the threshold of the transistor 62, thereby turning it OFF. This releases the clamp which had been holding VBB to ground.

A charge pump (not shown) pumps the substrate to a negative voltage such as −3 volts. Charge pumps suitable for this purpose are disclosed for example, in U.S. Patents Nos. 4,336,466 and 4,403,158.

Also shown in Figure 2 is a representative switch 66 connecting the node 56 to Vcc. Switch 66 is controlled by the substrate voltage VBB and is closed when VBB equals, for example, −3 volts. This switch 66 is included because the transistor 58 should be maintained in an OFF condition during normal VCC transitions after power up in order to prevent the substrate voltage VBB from rising to ground.

Figure 3 shows a schematic diagram of a preferred embodiment of the present invention. This circuit diagram uses the same reference numerals as Figure 2. As can be seen, the circuit 50 includes the substrate clamp circuit 52, Vcc, transition sense circuitry 70 (in a dashed line box) and stable power sense circuitry 72 which generally refers to circuitry which is shown to the left of the transistor 64 and is outside the box 70. The general operation of this circuitry has already been explained with reference to Figure 2.

Referring now to the further elements of Figure 3, a P channel transistor 80 has its drain coupled to a node 82 and its source coupled to VCC. Node 82 is coupled to one side of a capacitor 84 as well as being coupled to the gate of P channel transistor 66. The gate of the transistor 80 is coupled to one side of another capacitor 86 whose other side is coupled to ground. A node 88 is located schematically between the non ground side of the capacitor 86 and the gate of the transistor 80. The node 82 is coupled to the gate of an N channel transistor 90 whose source-drain path selectively couples the node 56 to one side of a large capacitor 92 whose other side is grounded. A further node 94 is located between the drain of the transistor 90 and the non grounded side of the capacitor 92.

The operation of these elements is as follows. On power-up, the voltage at node 82 follows Vcc upwards in voltage because it is pulled up by the transistor 80 and the capacitor 84. This function of the transistor 80 occurs because its gate is coupled to the node 88 which is held at ground by the capacitor 86. This permits transistor 80 to turn ON and couple Vcc to node 82.

When node 82 rises in voltage, it turns on the transistor 90 whose source-drain path then couples the node 94 to the node 56. The capacitor 92 which couples node 94 to ground has a large capacitance of the order of 50 picofarads which contributes to the delay at node 56 relative to the transistor 54.

As mentioned, the transistor 58 should remain OFF after Vcc is powered up or else the substrate voltage VBB will rise to ground causing certain circuits to stop working. To ensure against this, the transistor 66 is used. Node 82 goes negative when the substrate voltage VBB reaches a sufficiently negative voltage. This turns ON the P channel transistor 66 which prevents conduction of the transistor 58.

When Vcc is stable, the clamping transistor 62 is OFF. In addition, a transistor 96 is OFF, thereby allowing the voltage at node 88 to go high which, because it is coupled to the gate of a transistor 98, causes the transistor 98 to turn ON. The source-drain path of the transistor 98 couples VBB to another transistor 100, which turns ON after the substrate voltage VBB becomes negative. This, in turn, causes the node 82 to drop low from its high condition, which turns ON the P channel transistor 66. Thus, when the substrate voltage VBB reaches a sufficiently negative voltage, the transistor 66 turns ON to prevent further clamping of the substrate to ground.

In the event that Vcc drops to ground after having been stable long enough for circuit 50 to stabilize, circuit 50 includes provisions to reset itself, rather than "remembering" that Vcc is stable. Without such provision, the clamping of the substrate to ground may not occur, and latch-up could ensue.

Thus, when Vcc goes to ground, a transistor 102, which is within Vcc transition sense circuitry 70 and which has its gate coupled to its source, will cause node 56 to drop to ground. Similarly, an N-channel transistor 104 is coupled in like fashion to node 94. In the power up sense circuitry 72, a transistor 106, similarly configured, operates similarly with respect to node 88.

Further, to prepare for additional clamping in the event that Vcc should later drop to ground, during the stable power-up, the large capacitor 92 discharges to ground via the source-drain path of a transistor 108. An inverter 110 controls the gate of the transistor 108 for this purpose. Thus, instead of waiting for the capacitor 92 to discharge upon resetting, the capacitor 92 is prepared for a further use.

When a stable power-up is sensed, the voltage at the gate and at the source of the transistor 96 become equal in potential by way of the transistor 64. When this happens, transistors 112 and 114 pull up node 88. When voltage VBB drops in potential due to the charge pump, a node 116 also drops. Node 82 drops because of the source-drain path of a transistor 100. As discussed, after node 82 goes low, the transistor 58 is shut OFF.

When node 82 goes to ground, a transistor 118 pulls node 88 all the way to Vcc. The reason for this is that the transistor 80 should be OFF but this can occur only if node 88 is at Vcc. Because the transistors 112 and 114 are N channel devices, there are voltage drops associated with them which lower the voltage at node 88. Thus, the source-drain path of transistor 118 couples Vcc to node 88 (from the source-drain path of the transistor 66).

Figure 4 schematically illustrates the relationship of the substrate clamp 50 on substrate 10. The clamping transistor 62 is illustrated. Reference was made previously in this specification to a charge pump circuit which is designated as 120 in Figure 4. Thus, it can be seen that the circuitry, including the substrate clamp transistor, and the charge pump circuitry can all be included on the same P-type substrate as the remaining, other circuits 122, such as memory cells which may be formed on this substrate.

Figure 5 schematically illustrates the additional capacity which may be added to the chip. Figure 5 does not illustrate the circuit components of the chip, but is only intended to illustrate that substrate 10 is covered with a thin oxide 124. The oxide 124 can, for example, be silicon dioxide having a thickness of between about 200 and 1000 angstroms. Situated over this thin oxide is a plate, for example, of polysilicon having a thickness of 4000 to 5000 angstroms. The plate 126 is coupled to ground, that is, to the Vss pin 128. The arrangement of the plate 126 separated by an insulator 124 from another large plate 10 forms a large capacitor which is used to keep the substrate from bouncing in voltage. Parasitic devices are generally capacitively coupled to the substrate, and the added capacity provided by the arrangement of the elements 124 and 126 reduces the effects of such parasitic capacitance.

Figure 6 is provided to show schematically the added capacity. Figure 6 illustrates the P substrate 10 having an N well 12 therein. The P+ region 14 and the N+ region 20 are formed within the well 12 and the P+ region 28 and the N+ region 26 are formed outside the well. The transistors 30 and 32 which are susceptible to latch-up are illustrated. The substrate resistance 34 is shown connecting the region 28 to the base of the transistor 30. A well resistance 38 is shown between the well 12 and the collector of the transistor 32. Capacitances 130 are also shown between the ground connection Vss and the substrate 10. These capacitances are relatively high compared to the capacitance of parasitic devices which can lead to latch-up. The reason for this capacitance addition is that the charge pump only weakly holds the substrate to, for example, −3 volts. Local capacitance and resistive disturbances can couple the substrate in localized regions to a voltage above ground so that the transistor 30 can turn ON. Thus, the substrate capacity 130 is maximized with respect to local coupling capacitances.

It is to be appreciated that node 36 (Figure 1) is biased with a negative potential through the operation of the disclosed circuitry. This prevents parasitic transistor 30 from turning ON during power-up. Additionally, the capacitance between the substrate and ground is made high compared to capacitance couplings to the substrate from other sources.

In the preferred embodiment of the present invention, the width/length of the various transistors is as follows:

| Transistor 58 | 800 (width) |
|---|---|
| Transistor 62 | 25,000 (width) |
| Transistor 64 | 4/100 |
| Transistor 66 | 100 (width) |
| Transistor 80 | 6 (width) |
| Capacitor 84 | 79/20 |
| Capacitor 86 | 53/10 |
| Transistor 90 | 100 (width) |
| Capacitor 92 | 525/50 |
| Transistor 96 | 50 (width) |
| Transistor 98 | 20 (width) |
| Transistor 100 | 100/5 |
| Transistor 102 | 50 (width) |
| Transistor 104 | 200 (width) |
| Transistor 106 | 20 (width) |

| Transistor 108 | 20 (width) |
| Transistor 112 | 6/6 |
| Transistor 114 | 6/6 |
| Transistor 118 | 6 (width) |

## Claims

1. A method for controlling latch-up in a CMOS circuit on a substrate comprising operating the CMOS circuit, biasing the substrate during normal circuit operation with a charge pump on the substrate to a voltage to prevent latch up, sensing a power supply transition, clamping the substrate to a known potential in response to sensing said power supply transition, and releasing said clamping after said power supply transition.

2. A method as claimed in Claim 1 further comprising providing a substrate to ground capacitance substantially greater than the normal parasitic capacitance.

3. A method as claimed in Claim 1 or 2, wherein said substrate is clamped to ground in response to sensing said power supply transition, and further comprising determining when said power supply transition has ended and releasing said clamping in response to said determining.

4. A method as claimed in Claim 2 or 3, wherein the potential to which said substrate is biased by the charge pump is detected, and further comprising inhibiting said clamping step when the substrate reaches a predetermined potential such that said clamping does not occur except during power supply transitions.

5. A method for controlling latch-up in a CMOS circuit on a substrate comprising the steps of: operating the CMOS circuit, biasing the substrate during normal circuit operation with a charge pump on the substrate to a voltage to prevent latch up, sensing a power supply transition, controlling the substrate potential in cooperation with said sensing step, and releasing said control after said transition.

6. A method as claimed in Claim 5, further comprising biasing the substrate after said power supply transition to provide a second control over the substrate potential.

7. A method as claimed in Claim 5 or 6, further comprising biasing the substrate after said releasing step.

8. Apparatus for controlling latch-up in a CMOS circuit on a substrate (10) comprising a bias circuit (120) coupled to the CMOS substrate for controlling the potential of the substrate (10) on which the CMOS circuit is located, means for selectively engaging said bias circuit, a sensing circuit (70) for sensing a power supply transition, said bias circuit (120) being responsive to said sensing circuit, and a clamping circuit (52) for clamping the substrate (10) to a known potential in response to a power supply transition sensed by said sensing circuit (70), said clamping circuit being arranged to release said clamp after said power supply transition.

9. An apparatus as claimed in Claim 8, further comprising a circuit (72) for detecting when the substrate reaches a predetermined potential, said clamping circuit (52) being arranged to inhibit clamping in response to said detecting circuit (72).

10. An apparatus as claimed in Claim 8 or 9, wherein said clamping circuit is arranged to clamp the substrate to ground in response to a power supply transition sensed by said sensing circuit.

11. An apparatus as claimed in any of Claims 8 to 10, wherein said bias circuit includes a charge pump (120) coupled to the CMOS substrate (10).

12. An apparatus as claimed in any of Claims 8 to 11, wherein said bias circuit (120) is arranged to bias the substrate (10) when the clamping circuit (52) releases the substrate from said known potential.

13. An apparatus as claimed in any of Claims 8 to 12, wherein said sensing circuit (70) is arranged to receive a power supply signal, (Vcc), said clamping circuit (52) is arranged to clamp said bias circuit (120) to ground potential in response to a power supply transition sensed by said sensing circuit, and the sensing circuit (70) is arranged to release said clamping circuit when the power supply transition has substantially ended such that the bias circuit (120) biases the substrate after the power supply transition.

14. An apparatus as claimed in any of Claims 8 to 13, wherein said clamping circuit (52) includes a clamping transistor (62) having its source-drain path coupling the substrate to ground, and wherein a control transistor (58) has its source-drain path coupled to connect a power supply voltage to the gate of said clamping transistor (62), and wherein means (54, 56) are coupled to the gate of said control transistor (58) for turning on said control transistor in response to a power supply transition.

15. An apparatus as claimed in Claim 14, further comprising means (66), controlled by the substrate voltage (VBB) coupled to control transistor (58) and arranged to maintain said control transistor (58) OFF when said substrate voltage has attained a predetermined potential to thereby prevent the power supply voltage (Vcc) being coupled to the gate of said clamping transistor.

16. An apparatus as claimed in any of Claims 8 to 15, further comprising means (Figure 5) for providing additional substrate to ground capacitance.

## Patentansprüche

1. Verfahren zum Überwinden des Latch - Up - Effekts in einer CMOS - Schaltung auf einem Substrat, dadurch gekennzeichnet, daß die CMOS - Schaltung in Betrieb genommen, das Substrat während des normalen Schaltungsbetriebs mit einer Ladungspumpe am Substrat auf eine Spannung zum Verhindern des Latch - Up - Effekts vorgespannt, eine Stromversorgungsschwankung erfaßt, das Substrat aufgrund der Erfassung einer Stromversorgungsschwankung an ein gegebenes Potential geklemmt und diese Klemmung nach der Stromversorgungsschwankung freigegeben wird.

2. Verfahren nach Anspruch 1, dadurch gekennzeichnet, daß eine Kapazität zwischen Substrat und Masse vorgesehen wird, welche wesentlich größer ist als die normale Streukapazität.

3. Verfahren nach Anspruch 1 oder 2, dadurch gekennzeichnet, daß das Substrat aufgrund der Erfassung der Stromversorgungsschwankung an Masse geklemmt wird, und daß festgestellt wird, wann die Stromversorgungsschwankung beendet ist und die Klemmung aufgrund dieser Feststellung freigegeben wird.

4. Verfahren nach Anspruch 2 oder 3, dadurch gekennzeichnet, daß das Potential, auf welches das Substrat durch die Ladungspumpe vorgespannt ist, gemessen wird, und daß der Klemmvorgang gehemmt wird, wenn das Substrat ein vorbestimmtes Potential erreicht, so daß der Klemmvorgang nur während der Stromversorgungsschwankungen erfolgt.

5. Verfahren zum Überwinden des Latch - Up - Effekts in einer CMOS - Schaltung auf einem Substrat, gekennzeichnet durch folgende Schritte: Betätigen der CMOS - Schaltung, Vorspannen des Substrats während des normalen Schaltungsbetriebs mit einer Ladungspumpe am Substrat auf eine Spannung zum Verhindern des Latch - Up - Effekts, Erfassen einer Stromversorgungsschwankung, Steuern des Substrat - Potentials in Zusammenwirkung mit dem Erfassungsschritt und Freigeben dieser Steuerung nach der Schwankung.

6. Verfahren nach Anspruch 5, dadurch gekennzeichnet, daß das Substrat nach den Stromversorgungsschwankung vorgespannt wird, um eine zweite Kontrolle über das Substrat - Potential zu erzielen.

7. Verfahren nach Anspruch 5 oder 6, dadurch gekennzeichnet, daß das Substrat nach dem Freigabevorgang vorgespannt wird.

8. Vorrichtung zum Überwinden des Latch - Up - Effekts in einer CMOS - Schaltung auf einem Substrat (10), gekennzeichnet durch eine Vorspannschaltung (120), die an das CMOS - Substrat gekoppelt ist, um das Potential des Substrats (10) zu steuern, auf welchem die CMOS - Schaltung untergebracht ist, eine Einrichtung zum wahlweisen Einschalten der Vorspannschaltung, eine Erfassungsschaltung (70) zum Erfassen einer Stromversorgungsschwankung, wobei die Vorspannschaltung (120) auf die Erfassungsschaltung anspricht, eine Klemmschaltung (52) zum Klemmen des Substrats (10) an ein gegebenes Potential aufgrund einer durch die Erfassungsschaltung (70) erfaßten Stromversorgungsschwankung, wobei die Klemmschaltung derart ausgelegt ist, daß sie die Klemmung nach der Stromversorgungsschwankung freigibt.

9. Vorrichtung nach Anspruch 8, gekennzeichnet durch eine Schaltung (72) zum Feststellen wenn das Substrat ein vorbestimmtes Potential erreicht, wobei die Klemmschaltung (52) derart ausgelegt ist, daß sie die Klemmung in Abhängigkeit von der Erfassungschaltung (72) verhindert.

10. Vorrichtung nach Anspruch 8 oder 9, dadurch gekennzeichnet, daß die Klemmschaltung derart ausgelegt ist, daß sie das Substrat aufgrund einer von der Erfassungsschaltung erfaßten Stromversorgungsschwankung an Masse klemmt.

11. Vorrichtung nach einem der Ansprüche 8 bis 10, dadurch gekennzeichnet, daß die Vorspannschaltung eine an das CMOS-Substrat (10) gekoppelte Ladungspumpe (120) umfaßt.

12. Vorrichtung nach einem der Ansprüche 8 bis 11, dadurch gekennzeichnet, daß die Vorspannschaltung (120) derart ausgelegt ist, daß sie das Substrat (10) vorspannt, wenn die Klemmschaltung (52) das Substrat von dem gegebenen Potential abklemmt.

13. Vorrichtung nach einem der Ansprüche 8 bis 12, dadurch gekennzeichnet, daß die Erfassungsschaltung (70) derart ausgelegt ist, daß sie ein Stromversorgungs - Signal (Vcc) empfängt, daß die Klemmschaltung (52) derart ausgelegt ist, daß sie die Vorspannschaltung (120) aufgrund einer von der Erfassungsschaltung erfaßten Stromversorgungsschwankung an das Erdpotential klemmt, und daß die Erfassungsschaltung (70) derart ausgelegt ist, daß sie die Klemmschaltung freigibt, wenn die Stromversorgungsschwankung im wesentlichen beendet ist, so daß die Vorspannschaltung (120) das Substrat nach der Stromversorgungsschwankung vorspannt.

14. Vorrichtung nach einem der Ansprüche 8 bis 13, dadurch gekennzeichnet, daß die Klemmschaltung (52) einen Klemmtransistor (62) enthält, dessen Source - Drain - Stromweg das Substrat an Masse koppelt, und daß sie einen Steuer - Transistor (58) aufweist, dessen Source - Drain - Stromweg derart gekoppelt ist, daß er eine Stromversorgungsspannung mit der Gate - Elektrode des Klemmtransistors (62) verbindet, und daß eine Einrichtung (54, 56) mit der Gate - Elektrode des Steuertransistors (58) gekoppelt ist, um den Steuertransistor aufgrund einer Stromversorgungsschwankung durchzuschalten.

15. Vorrichtung nach Anspruch 14, gekennzeichnet durch eine von der Substratspannung (VBB) gesteuerte Einrichtung (66), welche mit dem Steuertransistor (58) gekoppelt und derart ausgelegt ist, daß sie den Steuertransistor (58) gesperrt hält (OFF), wenn die Substratspannung ein vorbestimmtes Potential erreicht hat, um dadurch zu verhindern, daß die Stromversorgungsspannung (Vcc) an die Gate - Elektrode des Klemmtransistors gekoppelt wird.

16. Vorrichtung nach einem der Ansprüche 8 bis 15, gekennzeichnet durch eine Einrichtung (Fig. 5) zur Ausbildung einer zusätzlichen Kapazität zwischen Substrat und Masse.

**Revendications**

1. Un procédé pour maîtriser le déverrouillage dans un circuit CMOS formé sur un substrat, dans lequel on fait fonctionner le circuit CMOS, on polarise le substrat, pendant le fonctionnement normal du circuit, avec une pompe de charge incorporée sur le substrat, à une tension qui empêche le déverrouillage, on détecte une transition de tension d'alimentation, on fixe le niveau du substrat à un potentiel connu sous l'effet de la détection de la transition de tension d'alimentation, et on supprime la fixation de niveau après la transition de tension d'alimentation.

2. Un procédé selon la revendication 1, comprenant en outre l'établissement d'une capacité substratmasse notablement supérieure à la capacité parasite normale.

3. Un procédé selon la revendication 1 ou 2, dans lequel le substrat est fixé au niveau de la masse sous l'effet de la détection de la transition de tension d'alimentation, et comprenant en outre la détermination du moment auquel la transition de tension d'alimentation s'est terminée, et la suppression de la fixation de niveau sous l'effet de cette détermination.

4. Un procédé selon la revendication 2 ou 3, dans lequel on détecte le potentiel auquel le substrat est polarisé par la pompe de charge, et comprenant en outre l'interruption de l'étape de fixation de niveau lorsque le substrat atteint un potentiel prédéterminé, de façon que cette fixation de niveau ne se produise que pendant des transitions de tension d'alimentation.

5. Un procédé pour maîtriser le déverrouillage dans un circuit CMOS formé sur un substrat, comprenant les étapes suivantes: on fait fonctionner le circuit CMOS, on polarise le substrat, pendant le fonctionnement normal du circuit, avec une pompe de charge incorporée sur le substrat, à une tension qui empêche le déverrouillage, on détecte une transition de tension d'alimentation, on commande le potentiel du substrat en coopération avec l'étape de détection, et on interrompt cette commande après la transition précitée.

6. Un procédé selon la revendication 5, dans lequel on polarise en outre le substrat après la transition de tension d'alimentation, pour exercer une seconde commande sur le potentiel du substrat.

7. Un procédé selon la revendication 5 ou 6, dans lequel on polarise en outre le substrat après l'étape d'interruption.

8. Dispositif pour maîtriser le déverrouillage dans un circuit CMOS formé sur un substrat (10), comprenant un circuit de polarisation (120) connecté au substrat CMOS pour commander le potentiel du substrat (10) sur lequel se trouve le circuit CMOS, des moyens pour mettre sélectivement en fonction ce circuit de polarisation, un circuit de détection (70) pour détecter une transition de tension d'alimentation, le circuit de polarisation (120) fonctionnant sous la dépendance du circuit de détection, et un circuit de fixation de nivau (52) pour fixer le niveau du substrat (10) à un potentiel connu, sous l'effet d'une transition de -tension d'alimentation détectée par le circuit de détection (70), ce circuit de fixation de niveau étant conçu de façon à interrompre la fixation de niveau après la transition de tension d'alimentation.

9. Un dispositif selon la revendication 8, comprenant en outre un circuit (72) destiné à détecter le moment auquel le substrat atteint un potentiel prédéterminé, et le circuit de fixation de niveau (52) étant conçu de façon à interrompre la fixation de niveau sous la dépendance du circuit de détection (72).

10. Un dispositif selon la revendication 8 ou 9, dans lequel le circuit de fixation de niveau est conçu de façon à fixer le substrat au niveau de la masse sous la dépendance d'une transition de tension d'alimentation qui est détectée par le circuit de détection.

11. Un dispositif selon l'une quelconque des revendications 8 à 10, dans lequel le circuit de polarisation comprend une pompe de charge (120) qui est connectée au substrat CMOS (10).

12. Un dispositif selon l'une quelconque des revendications 8 à 11, dans lequel le circuit de polarisation (120) est conçu de façon à polariser le substrat (10) lorsque le circuit de fixation de niveau (52) cesse de fixer le substrat au potentiel connu.

13. Un dispositif selon l'une quelconque des revendications 8 à 12, dans lequel le circuit de détection (70) est conçu de façon à recevoir un signal de tension d'alimentatioñ, (Vcc), le circuit de fixation de niveau (52) est conçu de façon à fixer le circuit de polarisation (120) au potentiel de la masse, sous l'effet d'une transition de tension d'alimentation qui est détectée par le circuit de détection, et le circuit de détection (70) est conçu de façon à interrompre le fonctionnement du circuit de fixation de niveau lorsque la transition de tension d'alimentation s'est pratiquement terminée, de façon que le circuit de polarisation (120) polarise le substrat après la transition de tension d'alimentation.

14. Un dispositif selon l'une quelconque des revendications 8 à 13, dans lequel le circuit de fixation de niveau (52) comprend un transistor de fixation de niveau (62) dont le chemin source-drain connecte le substrat à la masse, et dans lequel le chemin source-drain d'un transistor de commande (58) est connecté de façon à appliquer une tension d'alimentation à la grille du transistor de fixation de niveau (62), et dans lequel des moyens (54, 56) sont connectés à la grille du transistor de commande (58), pour débloquer ce transistor de commande sous l'effet d'une transition de tension d'alimentation.

15. Un dispositif selon la revendication 14, comprenant en outre des moyens (66), commandés par la tension de substrat (VBB), qui sont connectés au transistor de commande (58) et sont conçus de façon à maintenir le transistor de commande (58) à l'état bloqué, lorsque la tension de substrat a atteint un potentiel prédéterminé, pour empêcher ainsi l'application de la tension d'alimentation (Vcc) à la grille du transistor de fixation de niveau.

16. Un dispositif selon l'une quelconque des revendications 8 à 15, comprenant en outre des moyens (Figure 5) destinés à établir une capacité substrat-masse supplémentaire.

*FIG. 1*

*FIG. 2*

*FIG. 3*

1

*FIG. 4*

122

OTHER CIRCUITS

Vcc    50    62    120

10

*FIG. 5*

128

Vss

126

124

10

Vss    130    28    26    130    14    Vcc

P+    n+    P+    n+

n

Rwell

32    38

30

Rsub

12

34

10

P

*FIG. 6*